# EUROPEAN PATENT SPECIFICATION

(11) **EP 2 019 580 B1**
(45) Date of publication and mention of the grant of the patent: **19.12.2012**
(21) Application number: 08252357.2
(22) Date of filing: 10.07.2008
(51) Int. Cl.: H04Q 1/14, G02B 6/44, H05K 7/14, H02G 3/04, H04Q 1/02

(54) **Accessory Bracket**
Zubehörhalterung
Support d'accessoire

(30) Priority: 08.07.2008 US 169249; 12.07.2007 US 949413 P; 06.09.2007 US 970293 P
(43) Date of publication of application: 28.01.2009
(73) Proprietor: PANDUIT CORPORATION, Tinley Park, Illinois 60477-3091 (US)
(72) Inventor: Warmoth, Thomas B., Downers Grove, IL 60516 (US); Walker Jonathan D., Chicago, IL 60616 (US); Doorhy, Brendan F., Westmont, IL 60559 (US)
(74) Representative: Roberts, Gwilym Vaughan

(56) References cited:
- EP-A- 1 280 363
- US-A- 5 975 962
- US-A1- 2003 096 536
- US-A1- 2006 118 321

## Description

### FIELD OF INVENTION

This invention relates to apparatus for mounting rack mountable equipment/accessories to electronic equipment support structures and, more particularly, to grounded brackets for vertically mounting the rack mountable equipment/accessories.

### BACKGROUND

Typically, rack mountable equipment/accessories, such as patch panels, power distribution units (PDUs), switches, etc., are mounted within usable rack units (RUs) near the top of electronic equipment support structures, such as network cabinets, server cabinets, and 4 post racks. However, mounting the equipment/accessories in this manner has various drawbacks. For example, horizontally-mounted equipment/accessories occupy RUs that could be used for additional electronic equipment. In addition, by mounting the equipment/accessories near the top of the structure, patch cords that run between the equipment/accessories and other electronic equipment, such as servers, must be routed from the equipment/accessory horizontally to the side of the structure, vertically up the side of the structure, and horizontally over to the other equipment. To complete this routing can take patch cords from 1.5 m to 2.75 m (5 to 9 feet) in length to make the required connections. This makes equipment maintenance difficult when patch cords must be removed or replaced.

US 2006/0118321 discloses a patch panel assembly having a bracket with a base extending between first and second side walls. The bracket defines a cable receiving passageway. First and second patch panels are coupled to the first and second side walls for pivotal movement about first and second vertical pivot axes between open and closed positions. The patch panels are selectively engageable with one another in their closed positions for limiting access across the cable receiving passageway.

Therefore, there is a need for an accessory bracket that allows the mounting of standard rack mountable equipment/accessories, such that the rack mountable equipment/accessory does not occupy usable RUs and patch cord run length is reduced or minimized.

### SUMMARY

The invention is set out in the claims.

In one example, a bracket assembly for electronic equipment support structures has an elongated main body, a mounting tab extending from a first edge of the main body, and first and second mounting arms extending from a second edge of the main body, opposite the first edge. The mounting tab has an aperture formed therethrough. The first mounting arm is positioned adjacent a first end of the main body and extends generally perpendicular to the main body and the mounting tabs and the second mounting arm is positioned adjacent a second end of the main body, opposite the first end, and also extends generally perpendicular to the main body and the mounting tabs.

In another example, an electronic equipment support structure assembly has an electronic equipment support structure and a bracket assembly. The electronic equipment support structure has a vertically oriented member having a plurality of holes and the bracket assembly is interconnected with the vertically oriented member. The bracket assembly has an elongated main body, a mounting tab extending from the main body, and first and second mounting arms extending from the main body. The elongated main body is positioned adjacent to and generally parallel to the vertically oriented member and the mounting tab has an aperture that is aligned with at least one of the holes formed in the vertically oriented member. The first mounting arm is positioned adjacent a first end of the main body and extends generally perpendicular to the main body and the mounting tabs and away from the vertically oriented member and the second mounting arm is positioned adjacent a second end of the main body, opposite the first end, and extends generally perpendicular to the main body and the mounting tabs and away from the vertically oriented member.

In another example, a method for mounting rack mountable equipment to an electronic equipment support structure has the steps of: mounting a bracket assembly to a vertically oriented member of the electronic equipment support structure; positioning the rack mountable equipment adjacent and generally parallel to the vertically oriented member such that the equipment is in a generally vertical orientation; and connecting the rack mountable equipment to the bracket assembly between opposing mounting arms of the bracket assembly.

### BRIEF DESCRIPTION OF THE DRAWINGS

Certain examples of the present invention are illustrated by the accompanying figures. It should be understood that the figures are not necessarily to scale and that details that are not necessary for an understanding of the invention or that render other details difficult to perceive may be omitted. It should be understood, of course, that the invention is not necessarily limited to the particular examples illustrated herein.

Fig. 1 is a front perspective view of one example of an accessory bracket with a strain relief bar;

Fig. 2 is a front view of the accessory bracket and strain relief bar of Fig. 1;

Fig. 3 is a side view of the accessory bracket and strain relief bar of Fig. 1;

Fig. 4 is a front perspective view of the accessory bracket and strain relief bar of Fig. 1 with a patch panel frame;

Fig. 5 is a front view of the accessory bracket, strain relief bar, and patch panel frame of Fig. 4;

Fig. 6 is a side perspective view of a cabinet with multiple accessory brackets mounted therein;

Fig. 7 is an enlarged partial view of Fig. 6; and

Fig. 8 is an enlarged partial view of Fig. 7

Fig. 9 is a side perspective view of a 4 post rack with multiple accessory brackets mounted therein;

Fig. 10 is an enlarged partial view of Fig. 9;

Fig. 11 is a front view of the 4 post rack and accessory brackets of Fig. 9;

Fig. 12 is an enlarged partial view of Fig. 11;

Fig. 13 is an enlarged partial view of Fig. 12 showing one of the accessory brackets;

Fig. 14 is a partial side perspective view of Fig. 13;

Fig. 15 is an enlarged partial view of Fig. 12 showing the other accessory bracket; and

Fig. 16 is a partial side perspective view of Fig. 15.

### DETAILED DESCRIPTION

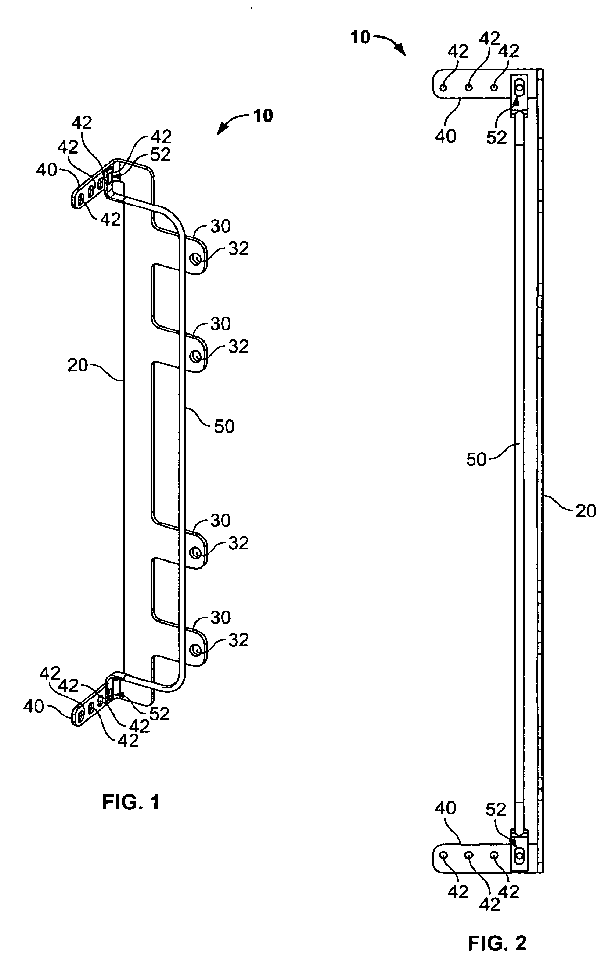

Referring to Figs. 1-3, one example of an accessory bracket 10 and strain relief bar 50 is shown. In the example shown, bracket 10 is configured to be mounted to the vertical frame rail or equipment rail of an electronic equipment support structure, such as a network cabinet, server cabinet, or 4 post rack, and can support various rack mountable equipment/accessories such as a standard 19-inch EIA patch panel frame, a standard 2-inch wide PDU, or a standard rack mounted switch, in a vertical orientation. The patch panel frame could include fiber adapter panels (FAPs), pre-terminated copper cartridges, six-port adapter fiber optic cassette modules, or other types of connectivity medium. In addition, as described in more detail below, bracket 10 could be extended such that multiple equipment/accessory units could be connected to bracket 10 in various combinations.

In the example shown, bracket 10 is generally L-shaped, is formed from an electrically conductive material, such as steel or aluminum, and generally has main body 20, mounting tabs 30 and mounting arms 40. Main body 20 provides the main support for bracket 10. In this example, bracket 10 is approximately 10.2 cm (4 inches) in width, 48.6 cm (19 1/8 inches) in length, with 1.7 cm (11/16 inch) wide and 7 cm (2 ¾ inch) long protrusions bent at 90 degrees to the rest of bracket 10 to form mounting arms 40.

Mounting tabs 30 extend from one edge of main body 20 and provide a means for connecting bracket 10 to the electronic equipment support structure. In this example, each mounting tab 30 is approximately 3.2 cm (1 1/4 inches) in width and 6.4 cm (2 1/2 inches) in length and has an elongated aperture 32 formed therethrough, which is configured to receive a mounting screw or bolt, as described in more detail below. Alternatively, the spaces between mounting tabs 30 could be eliminated. In other words, the spaces between each of the four mounting tabs 30 could be solid material. However, in this example, the material between the tabs has been removed in order to make bracket 10 lighter and make it possible to nest the blanks (punched-out shape before bending) within the raw material sheel size in order to yield more brackets from the stock material sheet size. Regardless, main body 20 should be at least 1.9 cm (¾ inches) wide in order to maintain the structure rigidity of bracket 10.

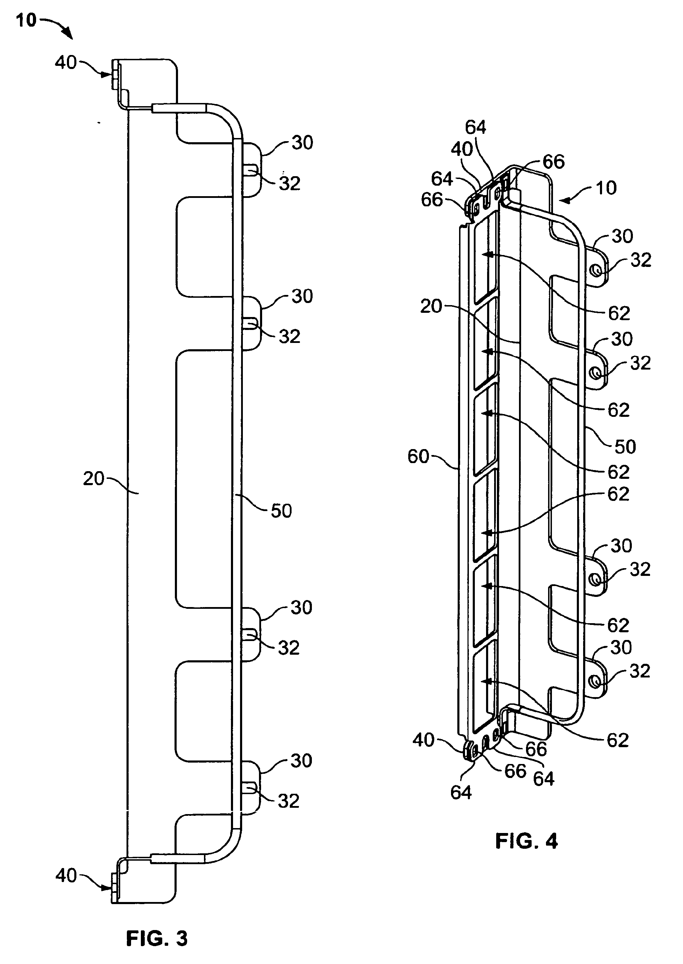

In this example, apertures 32 are elongated along the longitudinal axis of the corresponding mounting tab 30 to provide some flexibility in locating bracket 10 during installation. In addition, apertures 32 are also generally vertically aligned (as seen in Fig. 3) between each other such that apertures 32 will axially align with holes formed in the support structure. Alternatively, rather than having elongated apertures or slots 32, multiple apertures could be formed in each mounting tab 30 to provide multiple mounting options. In addition, in this example, four mounting tabs 30 are shown extending from the edge of main body 20. However, it will be understood that any number of mounting tabs could be used or one solid amounting tab with multiple apertures could be used. A minimum of two mounting slots or holes are required, but four slots help maintain an electrical ground path (continuity) from the equipment/accessory through bracket 10 to the support structure.

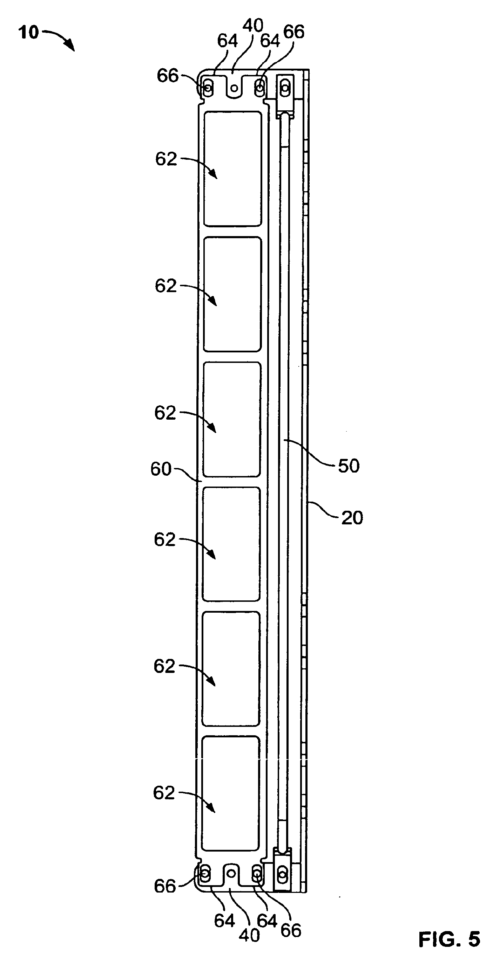

Mounting arms 40 extend from another edge of main body 20, opposite mounting tabs 30, are generally perpendicular to main body 20, and provide a means for supporting rack mountable electronic equipment/accessories, such as a patch panel frame 60 (see Figs. 4 and 5), PDU, switch, etc., in a vertical orientation. In this example, each mounting arm 40 is approximately 1.7 cm (11/16 inches) in width and 7 cm (2 3/4 inches) in length and has multiple holes 42 formed therethrough. A 7 cm (2 ¾ inch) long mounting arm 40 will provide a 1 ½ RU space (plus clearance) for one electronic equipment/accessory unit and one strain relief bar. A 9.5 cm (3 3/4 inch) long mounting arm 42 will provide a 2 RU space (plus clearance) that can be used to mount two electronic equipment/accessory units, one unit and up to two strain relief bars, or one unit and one open cable management bar. Holes 42 are aligned along the longitudinal axis of the corresponding mounting arm 40 and are spaced apart from each other such that holes 42 will align with holes 66 formed in a standard patch panel frame 60 (see Figs. 4 and 5) or other rack mountable equipment/accessor). Alternatively, rather than having multiple holes 42, one or more elongated apertures could be formed in each mounting arm 40 to provide more flexibility in mounting various electronic equipment/accessories, such as patch panel frames, PDUs, switches, etc. Holes 42 can be tapped to eliminate the nuts and make assembling the equipment/accessories to bracket 10 easier and less complicated. If nuts are used, it may take two hands to hold the components together before tightening.

In addition, in the example shown, mounting arms 40 are configured to support one electronic component/accessory and a strain relief bar 50. However, as discussed above, mounting arms 40 could be extended, and additional holes 42 formed therein, such that multiple electronic components/accessories or combinations thereof could be supported by each bracket 10. Moreover, an extender bracket can also be used to make the mounting arm longer.

As shown in Figs. 1-3, strain relief bar 50 can also be mounted to bracket 10. In this example, strain relief bar 50 is formed of an electrically conductive material, such as steel or aluminum, is generally U-shaped, and can be used for a variety of purposes, such as preventing cables from bending at an angle that could damage the cables, helping organize the cables, preventing the cables from getting pulled away from the connectors, and keeping the cables away from parts of the cabinet that can potentially move and pinch the cables. In this example, strain relief bar 50 is approximately 48.21 cm (18.98 inches) long and 7,14 cm (2,81 inches) deep, but could be made of varying shapes and sizes depending on the intended use. Elongated apertures 52 are formed in each end of strain relief bar 50 and are configured to be axially aligned with corresponding holes 42 in mounting arms 40 and to receive threaded members, which provides a means for mounting strain relief bar 50 to bracket 10.

To mount strain relief bar 50 to bracket 10, apertures 52 in strain relief bar 50 are aligned with holes 42 in mounting arms 40. A threaded member, such as a grounding (bond) screw or bolt, is inserted through apertures 52 and into holes 42 in mounting arms 40. If bolts are used, holes 42 will be configured to receive the threaded member therethrough and a nut will be threaded onto the bolt on the opposite side of mounting arm 40 from strain relief bar 50. If screws are used, holes 42 will be threaded and the screws will be threaded directly into the holes 42.

In the example described herein, strain relief bar 50 is grounded to bracket 10. Providing a ground path between strain relief bar 50 and bracket 10 can be accomplished in various well-known ways. For example, tri-lobular screws could be used that woald form threads in holes 42 and provide a ground path between mounting arms 40 and the tri-lobular screws To provide a ground path between the tri-lobular screws and strain relief bar 50, the screws could have serrated edges under the heads of the screws, a star washer could be used between the heads of the screws and strain relief bar 50, or areas in which the heads of the screws will contact strain relief bar 50 could be masked to exposed the bare metal (if strain relief bar 50 is not painted or coated, the heads of the screws will make direct metal to metal contact and masking is not required). Similarly, if nuts and bolts are used, the nuts and bolts could have serrated edges in the areas that will contact strain relief bar 50 and mounting arms 40, star washers could be used between the nuts and bolts and strain relief bar 50 and mounting arms 40, or areas in which the nuts and the heads of the bolts will contact strain relief bar 50 and mounting arms 40 could be masked to expose the bare metal (if strain relief bar 50 and/or mounting arms 40 are not painted or coated, the nuts and bolts will make direct metal to metal contact and masking is not required). A welded, soldered or terminated jumper cable with serrated screw or star washer could also be used.

Referring to Figs. 4 and 5, exemplary bracket 10 is shown with a standard patch panel frame 60 mounted in a vertical orientation. A standard patch panel frame 60, such as a 48.3 cm (19-inch) EIA patch panel frame, is typically 4.37 to 4.39 cm (1.72 to 1.73 inches) in width and 48.3 cm (19 inches) in length. A series of openings 62 are formed in frame 60 and are configured to receive various types of components, such as FAPs, pre-terminated copper cartridges, six-port adapter fiber optic cassette modules, etc., as is well-known in the art. Mounting ears 64 extend from the ends of frame 60 and each mounting ear 64 has a hole 66 formed therethrough. As can best be seen in Fig. 5, holes 66 in mounting ears 64 are configured to axially align with holes 42 in mounting arms 40 and to receive bolts or screws therethrough to allow the mounting of frame 60 to bracket 10.

By using bracket 10 to vertically orient electronic components/accessories un the side of a support structure, RUs that were occupied by electronic components/accessories are now open and can be used for additional electronic equipment. In addition, routing patch cables to the vertically-oriented electronic components/accessories is more efficient and cost effective because shorter cable lengths can be used. For example, by using bracket 10 to mount electronic components/accessories on the side of the support structure, next to other electronic equipment, patch cords as short as 45 cm to 61 cm (1 ½ to 2 feet) can be used. The use of shorter patch cords also makes equipment maintenance easier when patch cords must be removed or replaced.

To mount frame 60 to bracket 10, holes 66 in frame 60 are aligned with holes 42 in mounting arms 40. A threaded member, such as a screw or bolt, is inserted through holes 66 in frame 60 and into holes 42 in mounting arms 40. If bolts are used, holes 42 will be configured to receive the threaded member therethrough and a nut will be threaded onto the bolt on the opposite side of mounting arm 40 from frame 60. If screws are used, holes 42 will be threaded and the screws will be threaded directly into the holes 42.

In the example described herein, frame 60 is grounded to bracket 10. Providing a ground path between frame 60 and bracket 10 can be accomplished in various well-known ways. For example, tri-lobular screws could be used that would form threads in holes 42 and provide a ground path between mounting arms 40 and the tri-lobular screws. To provide a ground path between the tri-lobular screws and frame 60, the screws could have serrated edges under the heads of the screws, a star washer could be used between the heads of the screws and frame 60, or areas in which the heads of the screws will contact frame 60 could be masked to expose the bare metal (if frame 60 is not painted or coated, the heads of the screws will make direct metal to metal contact and masking is not required). Similarly, if nuts and bolts are used, the nuts and bolts could have serrated edges in the areas that will contact frame 60 and mounting arms 40, star washers could be used between the nuts and bolts and frame 60 and mounting arms 40, or areas in which the nuts and the heads of the bolts will contact frame 60 and mounting arms 40 could be masked to expose the bare metal (if frame 60 and/or mounting arm 40 are not painted or coated, the nuts and bolts will make direct metal to metal contact and masking is not required).

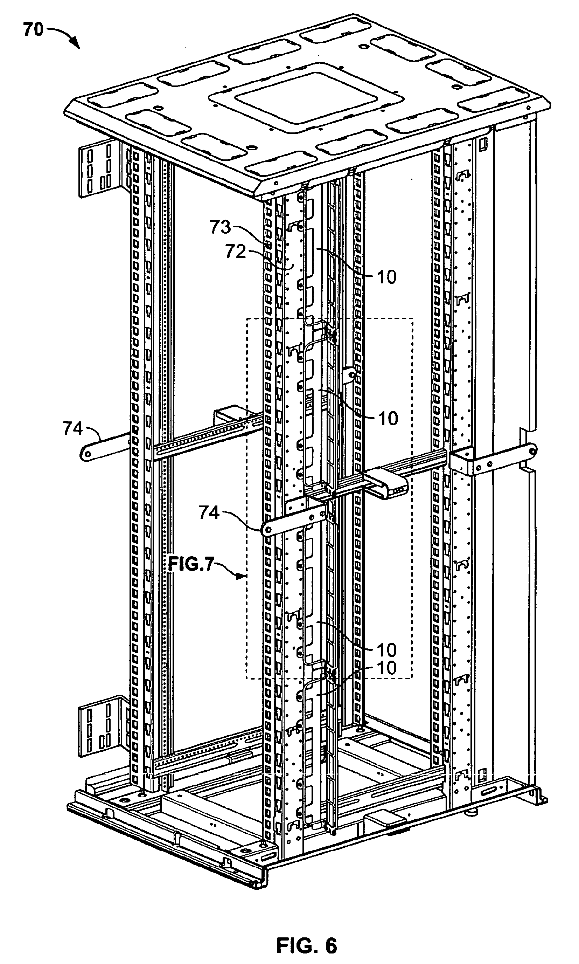

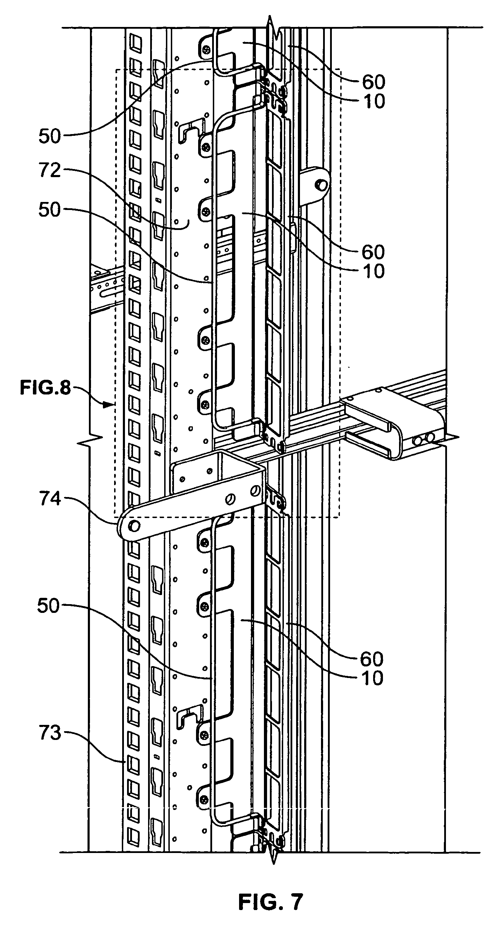

Referring now to Figs. 6-8, multiple exemplary accessory brackets 10 are shown mounted to the vertical frame rail 72 of an electronic equipment cabinet 70 (in Figs. 6-8 the front door, rear door, and side panels of cabinet 70 are not shown to expose the frame of the cabinet). As shown in Figs. 6-8 and described herein, cabinet 70 is a network cabinet, such as that shown and described in co-pending U.S. Patent Application Nos. 11/467,956; 11/538,884; 11/559,708; 11/623,358; 11/623,839; and 11/683,052. However, it will be understood that bracket 10 can be used with any type of cabinet or other electronic equipment support structure that is adapted to carry electronic equipment, such as servers. Furthermore, rather than mounting bracket 10 to vertical frame rail 72, bracket 10 could also be mounted to equipment rail 73, as discussed below, or any other portion of the cabinet support structure desired.

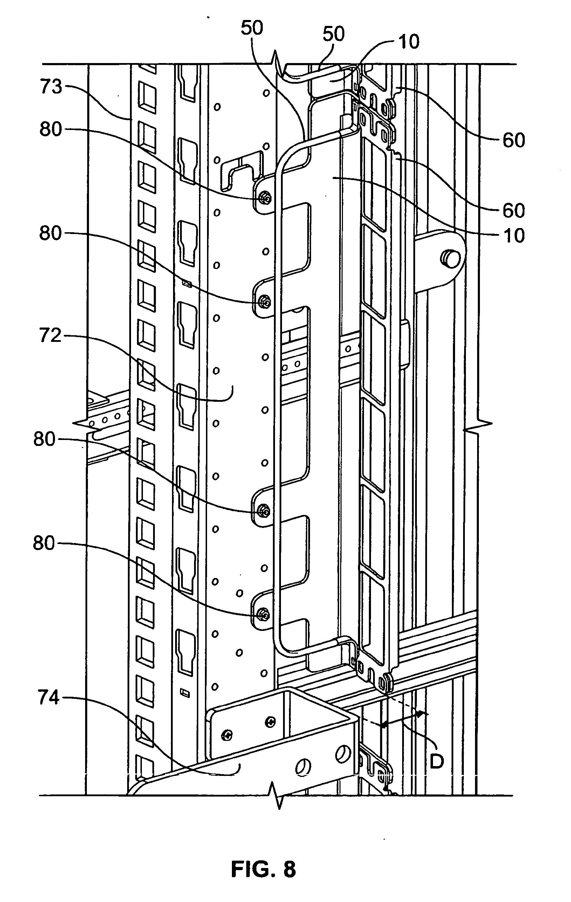

As can best be seen in Fig. 8, to mount bracket 10 to vertical frame rail 72, apertures 32 in mounting tabs 30 are aligned with holes formed in vertical frame rail 72. Mounting screws 80 are then inserted through holes 32 in mounting tabs 30 and are threaded into the holes in vertical frame rail 72. In the example shown, bracket 10 is configured to mount patch panel frame 60 at a maximum distance D of 14.3 cm (5 5/8 inches) from the rear face of vertical frame rail 72, with patch panel frame 72 facing the front of cabinet 70. This offset provides a safe zone to allow clearance between the side panel latches and any mounted equipment or cables attached to the mounted patch panel. In addition, the first tapped hole in mounting arm 40 is located approximately 1.47 cm (0.578 inches) from main body 20 in order to center patch panel frame 60 and strain relief bar 50 in between vertical frame rail 72 and side panel structural supports 74.

In addition, in the example shown, bracket 10 is grounded to vertical frame rail 72. Providing a ground path between bracket 10 and vertical frame rail 72 can be accomplished in various well-known ways. For example, mounting screws 80 could be tri-lobular screws that would form threads in the holes in vertical frame rail 72 and provide a ground path between vertical frame rail 72 and mounting screws 80. To provide a ground path between mounting screws 80 and bracket 10, screws 80 could have serrated edges under the heads of screws 80, a star washer could be used between the heads of screws 80 and bracket 10, or areas in which the heads of screws 80 will contact bracket 10 could be masked to expose the bare metal (if bracket 10 is not painted or coated, the heads of the screws will make direct metal to metal contact and masking is not required). A welded, soldered or terminated jumper cable with serrated screw or star washer could also be used.

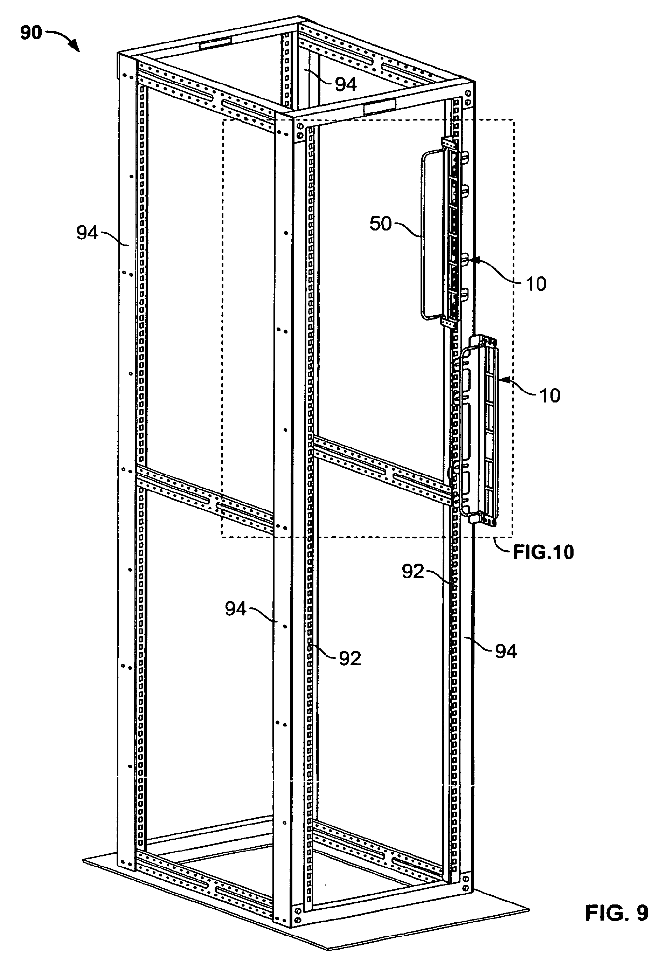

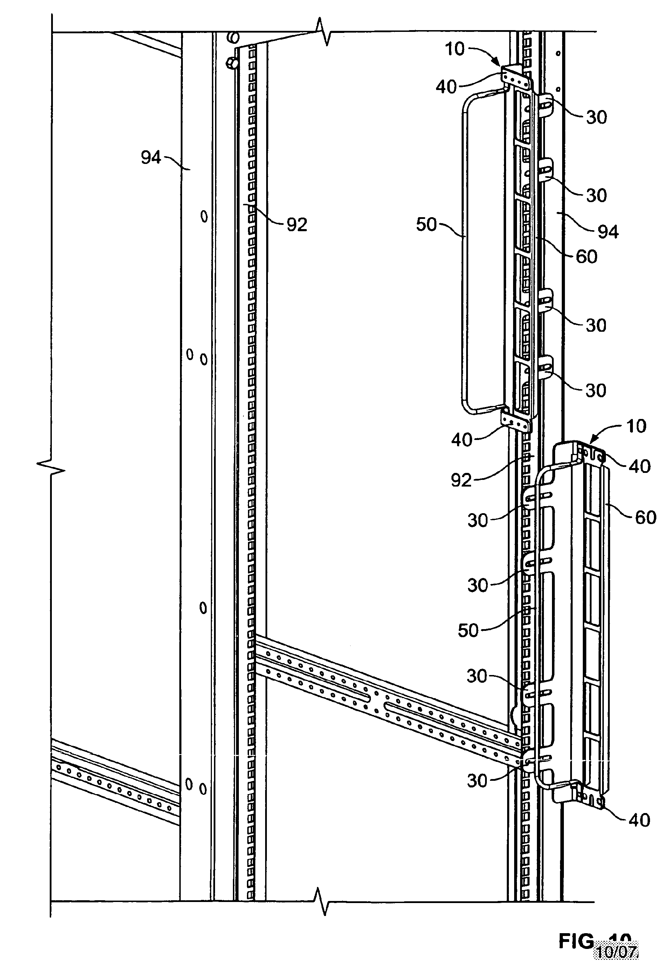

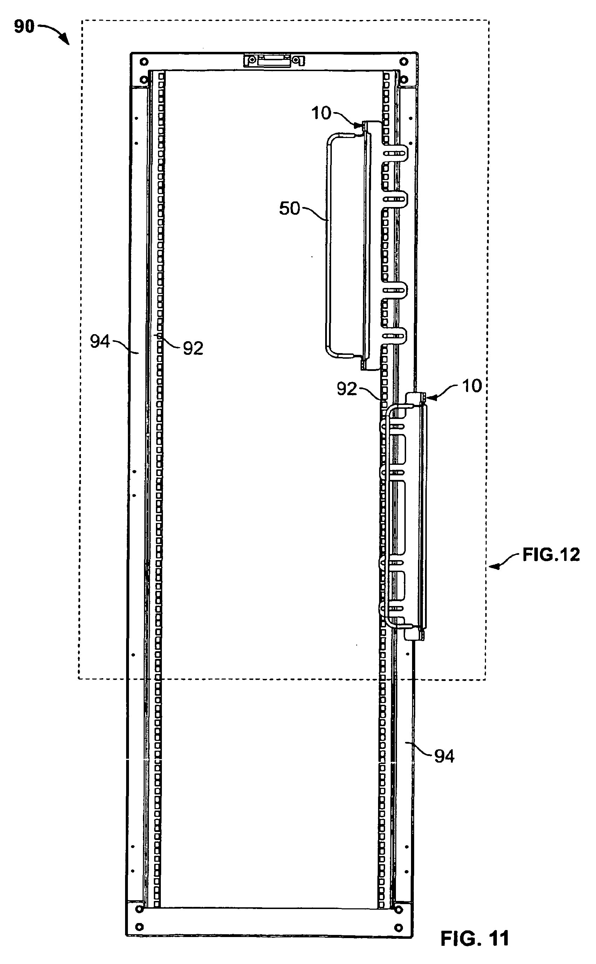

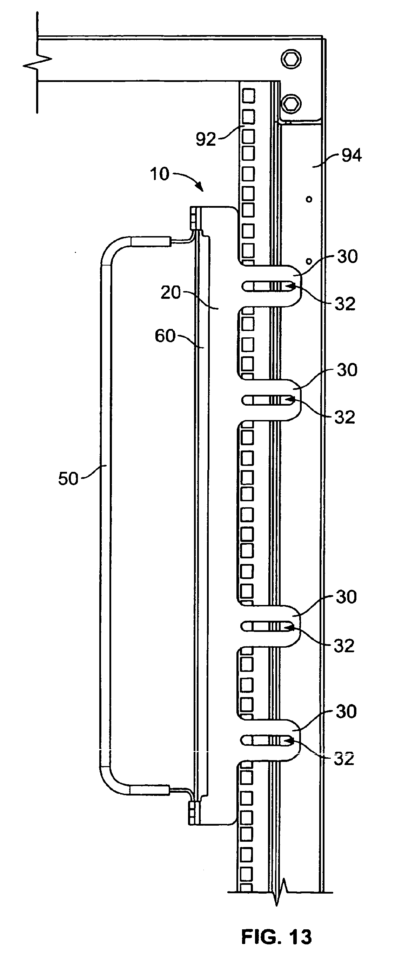

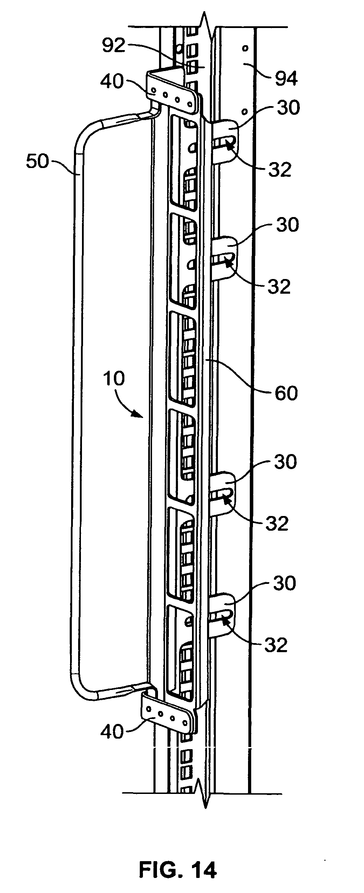

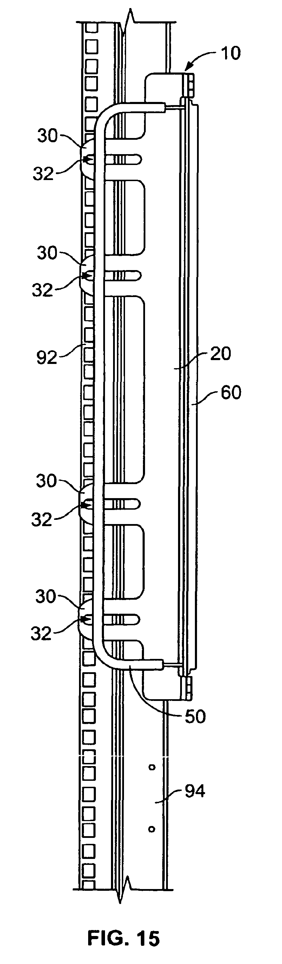

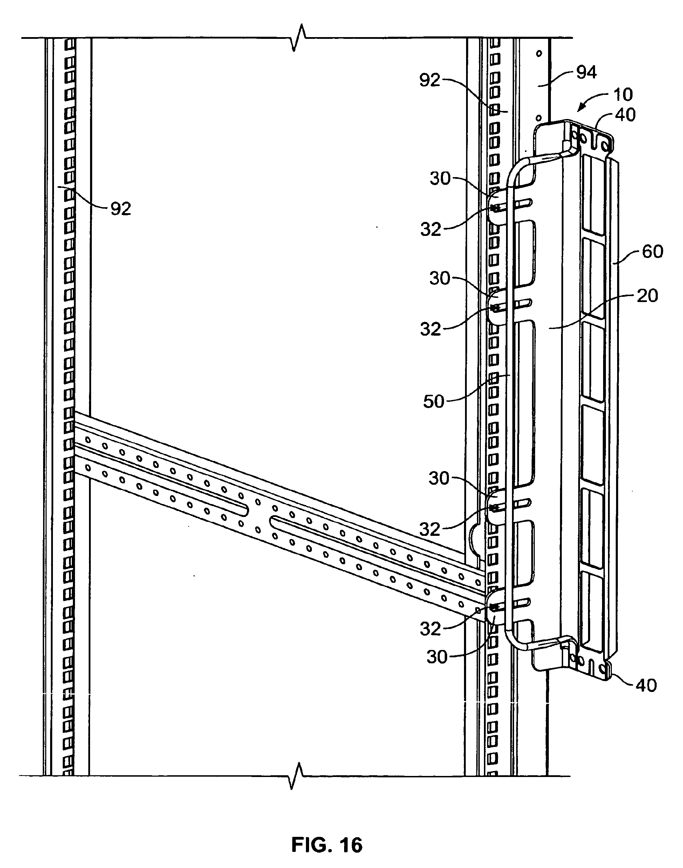

Referring now to Figs. 9-16, multiple exemplary accessory brackets 10 are shown mounted to the equipment rail 92 of a 4 post rack 90. Alternatively, rather than mounting bracket 10 to equipment rail 92, bracket 10 could also be mounted to vertical frame rail 94, as discussed above, or any other portion of the 4 post rack desired.

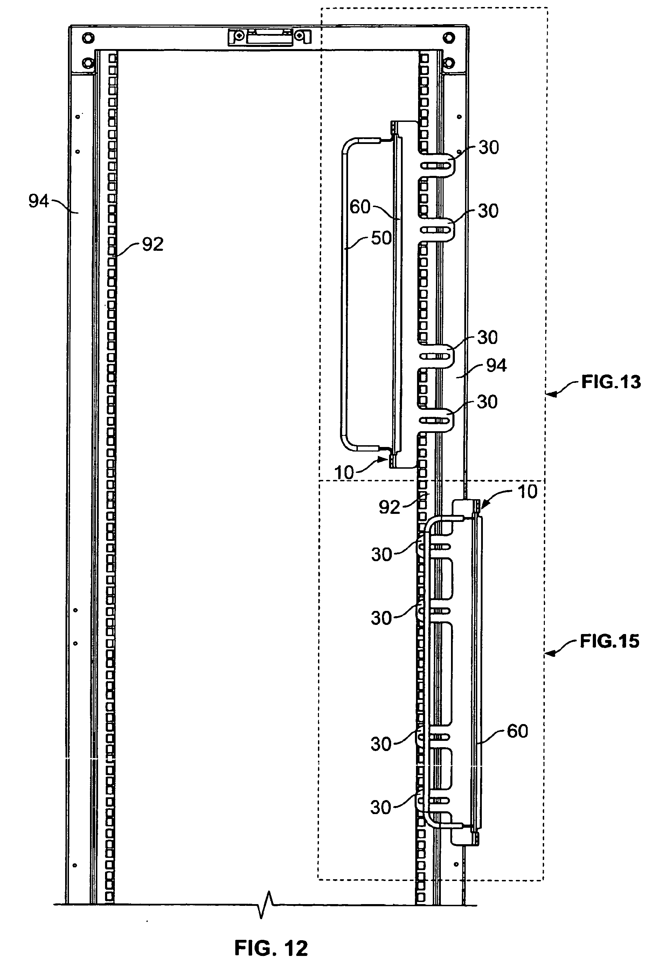

As can best be seen in Figs. 12, 13, and 15, to mount bracket 10 to equipment rail 92, apertures 32 in mounting tabs 30 are aligned with holes formed in equipment rail 92. Bolts (not shown) are then inserted through holes 32 in mounting tabs 30 and the holes in equipment rail 92 and a nut is threaded onto the bolt on the opposite side of equipment rail 92 from bracket 10.

In addition, in the example shown, bracket 10 is grounded to equipment rail 92. Providing a ground path between bracket 10 and equipment rail 92 can be accomplished in various well-known ways. For example, the nuts and bolts could have serrated edges in the areas that will contact bracket 10 and equipment rail 92, star washers could be used between the nuts and bolts and bracket 10 and equipment rail 92, or areas in which the nuts and the heads of the bolts will contact bracket 10 and equipment rail 92 could be masked to expose the bare metal (if bracket 10 and/or equipment rail 92 are not painted or coated, the nuts and bolts will make direct metal to metal contact and masking is not required).

## Claims

1. A bracket assembly (10) for mounting rack mountable equipment to an electronic equipment support structure (70), comprising:
an elongated main body (20);
a mounting tab (30) extending from a first edge of the main body (20) for connecting the bracket to the electronic support structure (70), the mounting tab (30) having an aperture (32) formed therethrough;
a first mounting arm (40) extending from a second edge of the main body (20), opposite the first edge, the first mounting arm (40) being positioned adjacent a first end of the main body (20) and extending generally perpendicular to the main body (20) and the mounting tab (30); and
a second mounting arm (40) extending from the second edge of the main body (20), the second mounting arm (40) being positioned adjacent a second end of the main body (20), opposite the first end, and extending generally perpendicular to the main body (20) and the mounting tab (30);
wherein the first mounting arm (40) and the second mounting arm (40) are configured to receive rack mountable equipment therebetween and position the rack mountable equipment such that a front of the rack mountable equipment is generally perpendicular to the main body (20) and the mounting tab (30).

2. The bracket assembly (10) of claim 1, wherein the first mounting arm (40) and the second mounting arm (40) each have a plurality of mounting holes (42) formed wherein, or wherein the first mounting arm (40) and the second mounting arm (40) each have an elongated mounting slot formed therein.

3. The bracket assembly (10) of claim 1 or 2, further comprising rack mountable equipment positioned between and interconnected with the mounting arms (40), and preferably wherein the rack mountable equipment is one of a patch panel frame, a power distribution unit, and a switch, or wherein the rack mountable equipment is electrically grounded to at least one of the mounting arms (40).

4. The bracket assembly (10) of any preceding claim, wherein the mounting tab (30) is configured to mount the bracket assembly (10) to the electronic equipment support structure (70) such that the elongated main body (20) is generally vertical and the support arms (40) extend generally horizontally, and preferably wherein the mounting tab (30) is configured to mount the bracket assembly (10) to one of vertical frame rail (72) of the electronic equipment support structure (70) and an equipment rail (73) of the electronic equipment support structure (70).

5. An electronic equipment support structure assembly, comprising:
an electronic equipment support structure (70) comprising a vertically oriented member (72) having a plurality of holes formed therein; and
a bracket assembly (10) as claimed in claim 1 interconnected with the vertically oriented member (72), wherein:
the elongated main body (20) of the bracket assembly (10) is positioned adjacent to and generally parallel to the vertically oriented member (72);
the aperture (32) formed in the mounting tab (30) of the bracket assembly (10) is aligned with at least one of the holes formed in the vertically oriented member (72); and
the first and second mounting arms (40) of the bracket assembly (10) extend away from the vertically oriented member (72).

6. The bracket assembly (10) of any of claims 1 to 4 or electronic equipment support structure assembly of claim 5, wherein the aperture (32) formed in the mounting tab (30) comprises an elongated slot, or further comprising a strain relief bar (50) mounted between the mounting arms (40), and preferably wherein the strain relief bar (50) is electrically grounded to at least one of the mounting arms (40).

7. The bracket assembly (10) of claim 5 or 6, further comprising rack mountable equipment positioned between and interconnected with the mounting arms (40) such that the equipment is positioned in a generally vertical orientation, and preferably wherein the rack mountable equipment is one of a patch panel frame, a power distribution unit, and a switch.

8. A method of mounting rack mountable equipment to an electronic equipment support structure (70), comprising the steps of:
mounting a bracket assembly (10) as claimed in claim 1 to a vertically oriented member (72) of the electronic equipment support structure (70);
positioning the rack mountable equipment adjacent and generally parallel to the vertically oriented member (72) such that the equipment is in a generally vertical orientation and a front of the rack mountable equipment is generally perpendicular to the main body (20) and a mounting tab (30) of the bracket assembly (10); and
connecting the rack mountable equipment to the bracket assembly (10) between opposing mounting arms (40) of the bracket assembly (10).

9. The electronic assembly of any of claims 5 to 7 or the method of claim 8, wherein the electronic equipment support structure (70) is one of a network cabinet, a server cabinet, and a four post rack, or wherein the vertically oriented member is one of a vertical frame rail (72) and an equipment rail (73).

10. The method of claim 8 or 9, wherein the rack mountable equipment is one of a patch panel frame, a power distribution unit, and a switch.

11. The method of any of claims 8 to 10 further comprising the step of mounting a strain relief bar (50) between opposing mounting arms (40) of the bracket assembly (10), and preferably further comprising the step of electrically grounding the strain relief bar (50) to the bracket assembly (10).

12. The method of any of claims 8 to 11 further comprising the step of electrically grounding the bracket assembly (10) to the vertically oriented member (72), or further comprising the step of electrically grounding the rack mountable equipment to the bracket assembly (10).

## Patentansprüche

1. Halteranordnung (10) zum Anbringen von an einem Gestell befestigbaren Zubehörs an einer Stützstruktur für elektronisches Zubehör (70), die aufweist:
einen länglichen Hauptkörper (20);
eine Befestigungslasche (30), die sich von einer ersten Kante des Hauptkörpers (20) erstreckt, um den Halter mit der elektronischen Stützstruktur (70) zu verbinden, wobei die Befestigungslasche (30) eine durch sie hindurchgehende Öffnung (32) hat;
einen ersten Befestigungsarm (40), der sich von einer zweiten Kante des Hauptkörpers (20), die der ersten Kante gegenüberliegt, erstreckt, wobei der erste Befestigungsarm (40) nahe einem ersten Ende des Hauptkörpers (20) angeordnet ist und sich im Allgemeinen senkrecht zum Hauptkörper (20) und zu der Befestigungslasche (30) erstreckt; und
einen zweiten Befestigungsarm (40), der sich von der zweiten Kante des Hauptkörpers (20) erstreckt, wobei der zweite Befestigungsarm (40) nahe einem zweiten Ende des Hauptkörpers (20), das dem ersten Ende gegenüberliegt, angeordnet ist und sich im Allgemeinen senkrecht zum Hauptkörper (20) und zu der Befestigungslasche (30) erstreckt;
wobei der erste Befestigungsarm (40) und der zweite Befestigungsarm (40) konfiguriert sind, um dazwischen an einem Gestell befestigbares Zubehör aufzunehmen und das an einem Gestell befestigbare Zubehör so zu positionieren, dass die Vorderseite des an einem Gestell befestigbaren Zubehörs im Allgemeinen senkrecht zum Hauptkörper (20) und zur Befestigungslasche (30) ist.

2. Halteranordnung (10) nach Anspruch 1, wobei der erste Befestigungsarm (40) und der zweite Befestigungsarm (40) jeweils eine Vielzahl von darin ausgebildeten Befestigungslöchern (42) aufweisen, oder wobei der erste Befestigungsarm (40) und der zweite Befestigungsarm (40) jeweils einen darin ausgebildeten länglichen Befestigungsschlitz aufweisen.

3. Halteranordnung (10) nach Anspruch 1 oder 2, die des Weiteren an einem Gestell befestigbares Zubehör aufweist, das zwischen den Befestigungsarmen (40) angeordnet und mit ihnen verbunden ist, und wobei vorzugsweise das an einem Gestell befestigbare Zubehör eines eines Stecktafelrahmens, einer Stromverteilungseinheit und eines Schalters ist, oder wobei das an einem Gestell befestigbare Zubehör an wenigstens einem der Befestigungsarme (40) geerdet ist.

4. Halteranordnung (10) nach einem der vorhergehenden Ansprüche, wobei die Befestigungslasche (30) konfiguriert ist, um die Halteranordnung (10) an der Stützstruktur für elektronisches Zubehör (70) zu befestigen, so dass der längliche Hauptkörper (20) im Allgemeinen vertikal ist und die Stützarme (40) sich im Allgemeinen horizontal erstrecken, und wobei vorzugsweise die Befestigungslasche (30) konfiguriert ist, um die Halteranordnung (10) an einem einer vertikalen Rahmenschiene (72) der Stützstruktur für elektronisches Zubehör (70) und einer Zubehörschiene (73) der Stützstruktur für elektronisches Zubehör (70) zu befestigen.

5. Stützstrukturanordnung für elektronisches Zubehör, mit:
einer Stützstruktur für elektronisches Zubehör (70), die ein vertikal ausgerichtetes Element (72) mit einer Vielzahl darin ausgebildeter Löcher aufweist; und
einer Halteranordnung (10) nach Anspruch 1, die mit dem vertikal ausgerichteten Element (72) verbunden ist, wobei:
der längliche Hauptkörper (20) der Halteranordnung (10) neben und im Wesentlichen parallel zu dem vertikal ausgerichteten Element (72) angeordnet ist;
die in der Befestigungslasche (30) der Halteranordnung (10) ausgebildete Öffnung (32) mit wenigstens einem der in dem vertikal ausgerichteten Element (72) ausgebildeten Löcher fluchtet; und
der erste und der zweite Befestigungsarm (40) der Halteranordnung (10) sich von dem vertikal ausgerichteten Element (72) weg erstrecken.

6. Halteranordnung (10) nach einem der Ansprüche 1 bis 4, oder Stützstrukturanordnung für elektronisches Zubehör nach Anspruch 5, wobei die in der Befestigungslasche (30) ausgebildete Öffnung (32) einen Längsschlitz aufweist, oder die des Weiteren eine Zugentlastungsstange (50) aufweist, die zwischen den Befestigungsarmen (40) angebracht ist, und wobei vorzugsweise die Zugentlastungsstange (50) an wenigstens einem der Befestigungsarme (40) elektrisch geerdet ist.

7. Halteranordnung (10) nach Anspruch 5 oder 6, die des Weiteren an einem Gestell befestigbares Zubehör aufweist, das zwischen den Befestigungsarmen (40) angeordnet und mit ihnen verbunden ist, so dass das Zubehör in im Allgemeinen vertikaler Ausrichtung angeordnet ist, und wobei vorzugsweise das an einem Gestell befestigbare Zubehör eines eines Stecktafelrahmens, einer Stromverteilungseinheit und eines Schalters ist.

8. Verfahren zum Befestigen an einem Gestell befestigbaren Zubehörs an einer Stützstruktur für elektronisches Zubehör (70), das die folgenden Schritte umfasst:
Befestigen einer Halteranordnung (10) nach Anspruch 1 an einem vertikal ausgerichteten Element (72) der Stützstruktur für elektronisches Zubehör (70);
Positionieren des an einem Gestell befestigbaren Zubehörs nahe und im Allgemeinen parallel zu dem vertikal ausgerichteten Element (72), so dass sich das Zubehör in einer im Allgemeinen vertikalen Ausrichtung befindet und die Vorderseite des an einem Gestell befestigbaren Zubehörs im Allgemeinen senkrecht zum Hauptkörper (20) und zu einer Befestigungslasche (30) der Halteranordnung (10) ist; und Verbinden des an einem Gestell befestigbaren Zubehörs mit der Halteranordnung (10) zwischen gegenüberliegenden Befestigungsarmen (40) der Halteranordnung (10).

9. Elektronische Anordnung nach einem der Ansprüche 5 bis 7, oder Verfahren nach Anspruch 8, wobei die Stützstruktur für elektronisches Zubehör (70) eines eines Netzwerkschranks, eines Serverschranks und eines Vierbein-Gestells ist, oder wobei das vertikal ausgerichtete Element eines einer vertikalen Rahmenschiene (72) und einer Zubehörschiene (73) ist.

10. Verfahren nach Anspruch 8 oder 9, wobei das an einem Gestell befestigbare Zubehör eines eines Stecktafelrahmens, einer Stromverteilungseinheit und eines Schalters ist.

11. Verfahren nach einem der Ansprüche 8 bis 10, das des Weiteren den Schritt des Anbringens einer Zugentlastungsstange (50) zwischen gegenüberliegenden Befestigungsarmen (40) der Halteranordnung (10) umfasst, und vorzugsweise des Weiteren den Schritt des elektrischen Erdens der Zugentlastungsstange (50) an der Halteranordnung (10).

12. Verfahren nach einem der Ansprüche 8 bis 11, das des Weiteren den Schritt des elektrischen Erdens der Halteranordnung (10) an dem vertikal ausgerichteten Element (72) umfasst, oder des Weiteren den Schritt des elektrischen Erdens des an einem Gestell befestigbaren Zubehörs an der Halteranordnung (10).

## Revendications

1. Ensemble de console (10) pour monter un équipement pouvant être monté sur bâti sur une structure de support d'équipement électronique (70), comprenant :
un corps principal allongé (20) ;
une patte de montage (30) s'étendant d'un premier bord du corps principal (20) pour raccorder la console à la structure de support électronique (70), la patte de montage (30) ayant une ouverture (32) formée à travers elle ;
un premier bras de montage (40) s'étendant d'un second bord du corps principal (20), opposé au premier bord, le premier bras de montage (40) étant positionné adjacent à une première extrémité du corps principal (20) et s'étendant généralement perpendiculairement au corps principal (20) et à la patte de montage (30) ; et
un second bras de montage (40) s'étendant du second bord du corps principal (20), le second bras de montage (40) étant positionné adjacent à une seconde extrémité du corps principal (20), opposé à la première extrémité, et s'étendant généralement perpendiculairement au corps principal (20) et à la patte de montage (30) ;
dans lequel le premier bras de montage (40) et le second bras de montage (40) sont configurés pour recevoir l'équipement pouvant être monté sur bâti entre ces derniers et positionner l'équipement pouvant être monté sur bâti de telle sorte qu'un avant de l'équipement pouvant être monté sur bâti est généralement perpendiculaire au corps principal (20) et à la patte de montage (30).

2. Ensemble de console (10) selon la revendication 1, dans lequel le premier bras de montage (40) et le second bras de montage (40) ont chacun une pluralité de trous de montage (42) formés à l'intérieur, ou dans lequel le premier bras de montage (40) et le second bras de montage (40) ont chacun une fente de montage allongée formée à l'intérieur.

3. Ensemble de console (10) selon la revendication 1 ou 2, comprenant en outre un équipement pouvant être monté sur bâti positionné entre et interconnecté avec les bras de montage (40), et de préférence dans lequel l'équipement pouvant être monté sur bâti est l'un d'un châssis de panneau de raccordement, d'une unité de distribution de l'énergie, et d'un commutateur, ou dans lequel l'équipement pouvant être monté sur bâti est relié électriquement à la masse à au moins un des bras de montage (40).

4. Ensemble de console (10) selon l'une quelconque des revendications précédentes, dans lequel la patte de montage (30) est configurée pour monter l'ensemble de console (10) sur la structure de support d'équipement électronique (70) de sorte que le corps principal allongé (20) est généralement vertical et les bras de support (40) s'étendent généralement horizontalement, et de préférence dans lequel la patte de montage (30) est configurée pour monter l'ensemble de console (10) sur l'un d'un longeron de cadre de châssis vertical (72) de la structure de support d'équipement (70) et d'un longeron d'équipement (73) de la structure de support d'équipement électronique (70).

5. Ensemble de structure de support d'équipement électronique, comprenant :
une structure de support d'équipement électronique (70) comprenant un organe orienté verticalement (72) ayant une pluralité de trous formés à l'intérieur ; et
un ensemble de console (10) tel que revendiqué dans la revendication 1 interconnecté à l'organe orienté verticalement (72), dans lequel :
le corps principal allongé (20) de l'ensemble de console (10) est positionné adjacent et généralement parallèle à l'organe orienté verticalement (72) ;
l'ouverture (32) formée dans la patte de montage (30) de l'ensemble de console (10) est alignée sur au moins l'un des trous formés dans l'organe orienté verticalement (72) ; et
les premier et second bras de montage (40) de l'ensemble de console (10) s'étendent en éloignement de l'organe orienté verticalement (72).

6. Ensemble de console (10) selon l'une quelconque des revendications 1 à 4 ou ensemble de structure de support d'équipement électronique selon la revendication 5, dans lequel l'ouverture (32) formée dans la patte de montage (30) comprend une fente allongée, ou comprenant en outre une barre anti-effort (50) montée entre les bras de montage (-40), et de préférence dans lequel la barre anti-effort (50) est reliée électriquement à la masse à au moins un des bras de montage (40).

7. Ensemble de console (10) selon la revendication 5, comprenant en outre un équipement pouvant être monté sur bâti positionné entre et interconnecté avec les bras de montage (40) de sorte que l'équipement est positionné dans une orientation généralement verticale, et de préférence dans lequel l'équipement pouvant être monté sur bâti est l'un d'un châssis de panneau de raccordement, d'une unité de distribution de l'énergie, et d'un commutateur.

8. Procédé de montage d'un équipement pouvant être monté sur bâti sur une structure de support d'équipement électronique (70), comprenant les étapes consistant à :
monter un ensemble de console (10) tel que revendiqué à la revendication 1 sur un organe orienté verticalement (72) de la structure de support d'équipement électronique (70) ;
positionner l'équipement pouvant être monté sur bâti adjacent et généralement parallèle à l'organe orienté verticalement (72) de sorte que l'équipement est dans une orientation généralement verticale et un avant de l'équipement pouvant être monté sur bâti est généralement perpendiculaire au corps principal (20) et à une patte de montage (30) de l'ensemble de console (10) ; et
raccorder l'équipement pouvant être monté sur bâti à l'ensemble de console (01) entre des bras de montage opposés (40) de l'ensemble de console (10).

9. Ensemble électronique selon l'une quelconque des revendications 5 à 7 ou procédé selon la revendication 8, dans lequel la structure de support d'équipement électronique (70) est l'un d'une baie réseau, d'une baie serveur, et d'un bâti à quatre montants, ou dans lequel l'organe orienté verticalement est l'un d'un longeron de cadre de châssis vertical (72) et d'un longeron d'équipement (73).

10. Procédé selon la revendication 8 ou 9, dans lequel l'équipement pouvant être monté sur bâti est l'un d'un châssis de panneau de raccordement, d'une unité de distribution de l'énergie, et d'un commutateur.

11. Procédé selon l'une quelconque des revendications 8 à 10, comprenant en outre l'étape consistant à monter une barre anti-effort (50) entre des bras de montage opposés (40) de l'ensemble de console (10), et comprenant en outre de préférence l'étape consistant à relier électriquement à la masse la barre anti-effort (50) à l'ensemble de console (10).

12. Procédé selon l'une quelconque des revendications 8 à 11, comprenant en outre l'étape consistant à relier électriquement à la masse l'ensemble de console (10) à l'organe orienté verticalement (72), ou comprenant en outre l'étape consistant à relier électriquement à la masse l'équipement pouvant être monté sur bâti à l'ensemble de console (10).
